# EUROPEAN PATENT APPLICATION

(11) **EP 1 045 434 A1**
(43) Date of publication of application: **18.10.2000**
(21) Application number: 99830216.0
(22) Date of filing: 15.04.1999
(51) Int. Cl.: H01L 21/322, H01L 21/265

(54) **Method for realizing integrated electronic devices on semiconductor substrates having gettering centres**

(71) Applicant: STMicroelectronics S.r.l., 20041 Agrate Brianza (Milano) (IT)
(72) Inventor: Caruso, Davide, 95030 Tremestieri Etneo (Catania) (IT); Ranieri, Vito, 95030 Mascalucia (Catania) (IT); Saggio, Mario, 95125 Catania (IT); Stagnitti, Umberto, 95012 Castiglione di Sicilia (Catania) (IT)
(74) Representative: Botti, Mario

(57) **Abstract**

This invention relates to a method for manufacturing electronic devices integrated monolithically in a semiconductor substrate delimited by two opposed front (3) and back (4) surfaces of a semiconductor material wafer (2). The method comprises at least a step of implanting ions of a noble gas, followed by a thermal treatment directed to form gettering microvoids in the semiconductor by evaporation of the gas. The ion implanting step is carried out through the back surface (4) of the semiconductor wafer (2) prior to starting the manufacturing process for the electronic devices, essentially before the step of cleaning the front surface (3) of the wafer (2).

## Description

This invention relates to a method for manufacturing electronic devices integrated monolithically in semiconductor substrates provided with gettering sites.

The invention also relates to a wafer of a semiconductor material for the manufacturing of electronic devices according to the above method.

Specifically, the invention relates to a method as above which comprises at least a step of implanting ions of a noble gas, followed by a thermal treatment to create bubbles through said semiconductor by evaporation of said gas.

### Prior Art

This technical field specifically requires that metal contaminants, as are normally to be found in semiconductor substrates and can seriously affect the performance of integrated circuits in such substrates, be trapped out.

The presence of metal impurities is always a source of trouble and malfunction in electronic semiconductor devices. Accordingly, the possibility of clearing the silicon of all metal impurities has been the subject of intensive study and research work in recent years.

To fill this demand, gettering techniques have been known which allow electronic devices, as integrated monolithically in a semiconductor provided with so-called gettering sites for trapping any metal contaminants present in the semiconductor, to be made.

Such gettering sites are created at the end of the processing steps that lead to the formation of integrated circuits. For the purpose, the front side of the semiconductor wafer is coated with a protective layer, and the back side of the wafer is cleaned and subjected to a step of POCl3 deposition or phosphorus (P) ion implantation, in order to produce certain extended faults in the semiconductor substrate.

These extended faults in the crystalline structure of the semiconductor effectively function as gettering sites capable of attracting and segregating metal atom impurities, as further described hereinafter.

This gettering technique involves, however, some manufacturing problems, since it is applied at the end of the manufacturing process and can impair the quality of circuits previously formed in the semiconductor wafer. In addition, the gettering efficiency of faults formed in this way is not particularly high.

More recently, the prior art proposed that microvoids be produced in the semiconductor by subjecting it to a step of implanting light ions of a noble gas, such as helium (He). These ions are highly permeable through silicon and implanted at a high concentration (> 5x10¹⁵ atoms/cm²) and low energy, such that gas bubbles are produced within the crystalline structure.

The energy level at which the implanting step is carried out represents no particular limitation to a successful implantation. In fact, a few keV to tens of MeV may be used. However, as the implanting energy increases, the minimum dosage for bubble formation also increases.

Optimum conditions for forming bubbles through the silicon are achieved at an implanting energy in the 50 to 300 keV range, as described in an article, "Gettering of metals by voids in silicon", Journal of Applied Physics, No. 78(6), September 15, 1995.

At energy levels below that, there occur phenomena of the semiconductor surface exploding, while at higher energy levels, such high implantation dosages must be used that the processing step ceases to be cost-efficient.

A thermal treatment applied after the implanting step, at a temperature above 700°C, allows the gas to diffuse through the crystalline structure up to the semiconductor surface, whence it will evaporate.

In evaporating, the gas leaves microvoids in the crystalline structure whose average diameter increases as the process temperature is increased. Also, these microvoids are confined locally within the projection regions of the implanted ions.

It has been found that the microvoids have a fault which is stable energetically in silicon. This means that, even subsequent to thermal treatments applied after the bubble forming, they do not evolve into crystallographic faults of another nature. This phenomenon is described in an article, ^{"}Efficiency and thermal stability of Pt gettering in crystalline Si", Journal of Applied Physics, No. 80(8), October 15, 1996.

On the surfaces of the microvoids formed as described above, there appear silicon atoms having unsaturated bonds and being highly reactive to impurities, in particular to such metal impurities as copper (Cu), platinum (Pt), or iron (Fe).

An example of a different application of microvoids produced by implanting He ions is known as a life span controlling tecnique and described in European Patent Application No. 0694960 by Co.Ri.M.Me., which discloses a process for producing microvoids from helium bubbles implanted beneath the active areas of an integrated electronic device.

The underlying technical problem of this invention is to provide a process for manufacturing electronic devices which are integrated monolithically in a semiconductor and have self-gettering features, that is an inherent capability of trapping out metal contaminants from the semiconductor.

### Summary of the Invention

The concept behind this invention is that of providing a semiconductor substrate with self-gettering properties by acting on the back side of a semiconductor wafer incorporating this substrate and before the wafer is subjected to the process steps that result in the integrated circuits being formed.

In essence, according to the invention, the back surface of the semiconductor wafer is pre-treated for the formation of gettering sites, prior to the wafer front polishing step.

Based on this concept, the technical problem is solved by a method as previously indicated and defined in the characterizing part of the appended Claim 1.

The technical problem is also solved by a wafer of a semiconductor material for manufacturing electronic devices or circuits integrated in a semiconductor substrate which is bounded by a front surface of the wafer and an opposed back surface thereof. The back surface of the wafer includes, according to the invention, gettering sites which have been formed by implanting ions of a noble gas, followed by thermal treatment to form bubbles through the semiconductor by evaporation of said gas.

The features and advantages of the method according to the invention will be apparent from the following description of an embodiment thereof, given by way of non-limitative example with reference to the accompanying drawings.

### Brief Description of the Drawings

Figure 1 is a vertical section view, drawn to an enlarged scale, showing schematically a portion of a semiconductor substrate as subjected to a step of the method according to the invention.
Figure 2 shows schematically the substrate portion of Figure 1 at a subsequent step of the inventive method.
Figure 3 shows schematically the substrate portion of Figure 2 at a further step of the inventive method.
Figure 4 shows schematically the substrate portion of Figure 3 at a final step of the inventive method.

### Detailed Description

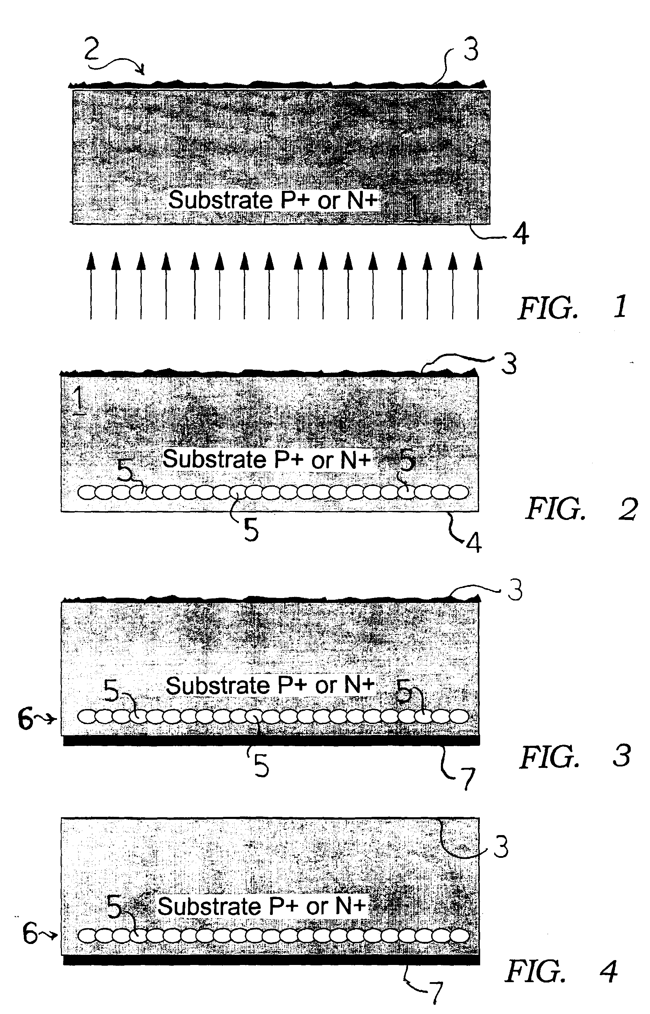

Referring to the drawing views, in particular the example of Figure 1, generally and schematically shown at 1 is a substrate of a semiconductor material, e.g. monocrystalline silicon, which has been subjected to sequential processing steps according to the method of this invention.

The process steps and the structures described herein below do not form a complete process flow for manufacturing integrated circuits. In fact, this invention can be practiced jointly with integrated circuit manufacturing techniques currently used in the art, and only those common process steps will be discussed herein as are necessary to an understanding of the invention.

The drawing figures which show cross-sections through a semiconductor wafer are not drawn to scale but rather to highlight major features of the invention.

The substrate 1 is incorporated to a so-called semiconductor wafer 2. This substrate may be doped either P+ or N+.

The wafer 2 has a surface 3 referred to as the front surface, which is still raw, in the sense that it will only later receive the pattern of an electronic device or circuit integrated monolithically in the semiconductor.

The wafer 2 has a back surface 4, opposite from the front surface 3. Reference will be made hereinafter to the front 3 and back 4 surfaces by the respective terms of front 3 and back 4 of the wafer 2.

Advantageously in this invention, the back 4 of the wafer 2 is subjected to ion implantation using ions of a noble gas, e.g. helium (He).

This implanting step is carried out at a fairly high dosage, preferably higher than 1x10¹⁶ atoms/cm².

The implantation energy used during this step is of approximately 20keV, preferably more.

This implantation step is the first step provided for forming microvoids in the semiconductor substrate 1 at the surface layer of the wafer 2 back 4.

The method of this invention provides for a subsequent thermal treatment applied at a temperature, referred to as intermediate for this kind of electronic component manufacturing process.

Specifically, the thermal treatment step is carried out at a temperature in the 600° to 800°C range. Preferably for this thermal treatment, the temperature should be higher than 700°C and maintained for about one hour in an inert medium of nitrogen (N₂).

This step of the inventive method allows the helium ions implanted in the substrate 1 to form bubbles within the crystalline structure of the semiconductor. As the thermal treatment progresses, the helium gas evaporates through the back 4 of the wafer 2 and leaves in the substrate an almost unbroken series of voids 5 whose diameters lie in the 10 to 100 nanometer (nm) range.

Also, these voids are confined to within a region which extends parallel to the back surface 4 of the wafer 2. This region extends close to the surface 4 and defines essentially a band 6 located 100 to 500 nm above the surface 4.

At this stage of the inventive method, a protective layer 7 is formed over the whole back surface 4 of the wafer 2.

This layer 7 can be formed conventionally by depositing a nitride or polysilicon or silicon dioxide layer using a vapox technique.

The method further provides for the front 3 of the wafer 2 to be polished, thereby making it ready to accept any standard process for manufacturing semiconductor monolithically integrated circuits.

The method of this invention yields, however, a wafer which incorporates a substrate having self-gettering properties. In essence, wafers produced in accord with the invention have a major advantage in that they include thermally stable trapping sites for metal impurities, since the efficiency of the microvoids is left unaltered by high-temperature thermal treatments (T=1200°C, t=5hr).

This relieves the integrated electronic devices manufacturing process of the steps required to create gettering sites at the end of the device manufacturing steps.

Furthermore, the method of this invention is of special advantage in all those cases where standard techniques cannot be used to provide gettering sites or regions.

An example of such cases would be that of SOI (Silicon-On-Insulator) substrates, which comprise essentially a pair of substrates isolated by an oxide layer.

By virtue of the inventive method yielding a substrate with self-gettering properties, the formation of SOI substrates including gettering sites is made much easier by the method of this invention.

In fact, a SOI substrate can be provided by superimposing on each other and bonding together two semiconductor wafers, each with a respective substrate. For example, a first wafer could include a standard substrate, and the second wafer include a substrate according to the invention having an insulating protective layer.

The first and second wafers can be superimposed on each other and bonded together such that the insulating layer will form a buried layer of the resultant structure. Alternatively, the insulating layer could well be a protective layer of the first wafer.

In either cases, the gettering site would locate next to the insulating layer of the substrate-insulator-substrate ply, i.e. in the best place to develop an effective gettering action.

Tests carried out at the Applicant's have shown that the method of this invention is cost-efficient compared to the other techniques currently employed in the industry. In addition, a highly efficient gettering action was achieved along with considerable stability to temperature.

## Claims

1. A method for manufacturing electronic devices integrated monolithically in a semiconductor substrate delimited by two opposed front (3) and back (4) surfaces of a semiconductor material wafer (2), which method comprises at least a step of implanting ions of a noble gas, followed by a thermal treatment directed to form gettering microvoids in said semiconductor by evaporation of said gas, characterized in that said ion implanting step is carried out through the back surface (4) of the semiconductor wafer (2) prior to starting the manufacturing process for said devices.

2. A method according to Claim 1, characterized in that said ion implanting step is carried out prior to a step of cleaning the front surface (3) of the wafer (2).

3. A method according to Claim 1, characterized by forming a protective layer (7) over the entire back surface (4) of the wafer (2).

4. A method according to Claim 1, characterized by superimposing said wafer on at least a second wafer of a standard type to thereby form a substrate of the SOI type.

5. A method according to Claim 1, characterized in that the implant dosage for said ion implanting step is higher than 1x10¹⁶ atoms/cm².

6. A method according to Claim 1, characterized in that the implantation energy for said ion implanting step is equal to or greater than 20keV.

7. A method according to Claim 1, characterized in that the thermal treatment is applied at a higher temperature than 700°C and maintained for about one hour in an inert medium.

8. A method according to Claim 1, characterized in that it comprises an additional step of implanting ions of a noble gas, followed by a thermal treatment directed to form gettering microvoids in non-active regions of the electronic devices formed on the front surface (3) of the wafer.

9. A wafer of a semiconductor material for forming electronic devices or circuits integrated in a semiconductor substrate which is delimited between a front surface (3) of the wafer (2) and an opposed back surface (4) thereof, characterized in that the wafer back surface (4) includes gettering microvoids formed by first implanting ions of a noble gas and then applying a thermal treatment to evaporate said gas.

10. A wafer according to Claim 9, characterized in that the wafer front surface (3) is a raw surface.
